# EUROPÄISCHE PATENTSCHRIFT

(11) **EP 0 871 272 B1**
(45) Veröffentlichungstag und Bekanntmachung des Hinweises auf die Patenterteilung: **01.08.2001**
(21) Anmeldenummer: 98106198.9
(22) Anmeldetag: 04.04.1998
(51) Int. Cl.: H02J 3/00

(54) **Verfahren zum Erfassen des Energieeinsparpotentials eines elektrischen Energieverbrauchersystems und Verfahren zum Betreiben eines elektrischen Engergieverbrauchersystems**
Method for determining the energy saving potential of an electrical energy consuming system and method for operating an electrical energy consuming system
Méthode pour déterminer le potentiel d'épargne d'énergie d'un système de consommation d'énergie électrique et méthode d'opération d'un système de consommation d'énergie électrique

(30) Priorität: 10.04.1997 DE 19714867
(43) Veröffentlichungstag der Anmeldung: 14.10.1998
(73) Patentinhaber: Steinigeweg, Dieter, Dipl.-Ing., 64289 Darmstadt (DE)
(72) Erfinder: Steinigeweg, Dieter, Dipl.-Ing., 64289 Darmstadt (DE)
(74) Vertreter: Weber, Dieter, Dr.

(56) Entgegenhaltungen:
- EP-A- 0 614 088
- ARRIOLA F J ET AL: "EXTENSION DES APPLICATIONS DE TEMPS REEL AUX ORDINATEURS D'ETUDES" ULSI SCIENCE AND TECHNOLOGY 1987, PHILADELPHIA, MAY 11 - 15, 1987, Nr. SYMP. 1, 28.August 1988, BROYDO S;OSBURN C M (EDS ), Seiten 1-11, XP000093439
- PAPALEXOPOULOS A D ET AL: "A REGRESSION-BASED APPROACH TO SHORT-TERM SYSTEM LOAD FORECASTING" IEEE TRANSACTIONS ON POWER SYSTEMS, Bd. 5, Nr. 4, 1.November 1990, Seiten 1535-1550, XP000173082
- GRADY W M ET AL: "ENHANCEMENT, IMPLEMENTATION, AND PERFORMANCE OF AN ADAPTIVE SHORT-TERM LOAD FORECASTING ALGORITHM" IEEE TRANSACTIONS ON POWER SYSTEMS, Bd. 6, Nr. 4, 1.November 1991, Seiten 1404-1410, XP000271891
- S.OR: "a weather sensitive model for short-term load forecasting" IEEE/CSEE JOINT CONFERENCE ON HIGH-VOLTAGE TRANSMISSION SYSTEMS IN CHINA , 17.Oktober 1987, CHINA, Seiten 245-251, XP002070545
- D.LIJESEN ET AL: "SHORT-TERM FORECASTING IN POWER SYSTEMS" ADVANCES IN INSTRUMENTATION, Bd. 25, Nr. 1, 26.Oktober 1970, USA, Seiten 1-7, XP002070546

## Beschreibung

Die vorliegende Erfindung betrifft ein Verfahren zum Erfassen des Energieeinsparpotentials eines (realen) elektrischen Energieverbrauchersystems.

Art und Typ des elektrischen Energieverbrauchersystems sind dabei prinzipiell beliebig, d.h. es könnte sich dabei um ein Einfamilienhaus, ein Hochhaus oder einen Wohnblock, ein Verwaltungsgebäude, eine Schule, eine Fabrik, ein Schwimmbad oder ein sonstiges elektrisches Energieverbrauchersystem handeln, wobei die Erfindung vorzugsweise auf solche elektrischen Energieverbrauchersysteme anzuwenden ist, auf welche nach Erfassung eines Energieeinsparpotentials auch eine entsprechende Einwirkung möglich ist, um dieses Einsparpotential zu nutzen. Dies gilt also insbesondere für Energieverbrauchersysteme, die zentral gesteuert und kontrolliert werden.

Dies schließt allerdings die Anwendung auf andere Systeme nicht aus, bei welchen das volle Einsparpotential nur dadurch ausgenutzt werden kann, daß dezentral und unabhängig voneinander die Kontrolle über einzelne Teilsysteme des elektrischen Energieverbrauchersystems ausgeübt wird, wie zum Beispiel in einem größeren Wohnblock, in welchem jeder einzelne Mieter oder Eigentümer einer Wohnung den jeweiligen Energieverbrauch in der Wohnung selbst bestimmt.

Die bisherigen Verfahren zum Erfassen des elektrischen Energieeinsparpotentials solcher Verbrauchersysteme sind sehr aufwendig und umfassen im allgemeinen die genaue Messung des Verbrauchs jedes einzelnen Verbrauchers in dem System, um daraus diejenigen Verbraucher zu ermitteln, die möglicherweise den größten Anteil am Energieverbrauch haben und/oder ein entsprechend großes Energieeinsparpotential haben könnten. Da eine solche Datenerfassung und -auswertung außerordentlich aufwendig und auch mit entsprechenden Kosten verbunden ist, scheuen viele Nutzer derartiger Energieverbrauchersysteme bzw. die hierfür zuständigen und verantwortlichen Personen vor der Erfassung des möglichen Energieeinsparpotentials zurück, so daß sich an dem Energieverbrauch und den Kosten hierfür auch nichts ändert.

Ein anderes übliches und weniger aufwendiges Verfahren besteht in der Anwendung rein statistischer Erfahrungswerte, wobei der durchschnittliche Energieverbrauch pro Quadratmeter bei vergleichbaren Objekten zugrundegelegt wird. Dieses Verfahren hat sich jedoch in der Praxis als weitgehend unbrauchbar erwiesen, da der auf diese Weise abgeschätzte und erwartete Energieverbrauch im Extremfall um mehrere 100 % von dem tatsächlichen Energieverbrauch abweichen kann, ohne daß sich daraus Hinweise auf die konkreten Quellen ergeben, welche für diese starken Abweichungen verantwortlich sind.

Gegenüber diesem Stand der Technik liegt der vorliegenden Erfindung die Aufgabe zugrunde, ein Verfahren zum Erfassen des Energieeinsparpotentials eines elektrischen Energieverbrauchersystems und ein entsprechendes Verfahren zum Steuern eines elektrischen Energieverbrauchersystems zu schaffen, welche gegenüber den herkömmlichen, bekannten Verfahren erheblich einfacher und weniger aufwendig sind und dennoch eine weitgehend zuverlässige Identifikation derjenigen Verbraucher und Verbrauchergruppen ermöglichen, welche das größte Energieeinsparpotential haben.

Diese Aufgabe wird gelöst durch ein Verfahren, welches die folgenden Schritte aufweist:
a) Messen der Kenndaten des elektrischen Energieverbrauchs, vorzugsweise nach Zeitfenstern aufgeschlüsselt sowie Integration dieser Kenndaten über einen vorgebbaren Zeitraum,
b) Auswählen eines ersten Modells für das elektrische Energieverbrauchersystem auf der Basis von Erfahrungswerten für vergleichbare Energieverbrauchersysteme, wobei das erste Modell veränderbare Parameter hat, und Integration der Kenndaten des elektrischen Energieverbrauchs des ersten Modells, gegebenenfalls in denselben Zeitfenstern wie bei dem realen System und über denselben vorgebbaren Zeitraum wie bei dem realen System,
c) Vergleich der gemessenen integrierten Kenndaten mit den auf der Grundlage des ersten Modells berechneten integrierten Kenndaten des elektrischen Energieverbrauchs und Bestimmen der Differenz der Kenndaten des Modells und des realen Systems,
d) Anpassen der Parameter des ersten Modells zur Erstellung eines zweiten Modells des elektrischen Energieverbrauchersystems, derart, daß die integrierten Kenndaten des zweiten Modells mit den entsprechenden integrierten gemessenen Kenndaten des realen Energieverbrauchersystems innerhalb vorgebbarer Toleranzen übereinstimmen und
e) Vergleichen der Parameter der ersten und zweiten Modelle zur Identifikation derjenigen Verbraucher des elektrischen Energieverbrauchersystems, welche den gegenüber dem ersten Modell abweichenden Verbrauch bewirken.

Im Gegensatz zum Stand der Technik wird also nicht der elektrische Energieverbrauch der einzelnen Verbraucher gemessen, sondern es wird der Verbrauch des Gesamtsystems erfaßt, vorzugsweise nach Zeitfenstern aufgeschlüsselt, wobei die Zeitfenster zweckmäßigerweise den Tageszeiten bzw. Zeiträumen für unterschiedliche Tarife für den elektrischen Energieverbrauch entsprechen. Außerdem wird dieser Energieverbrauch über einen längeren Zeitraum kumuliert, was die Datenerfassung bzw. -messung noch weiter vereinfacht. In vielen Fällen kann man sogar unmittelbar auf die von einem Energieversorgungsunternehmen bereitgestellten Kenndaten des elektrischen Energieverbrauchs zurückgreifen. Diese Kenndaten bestehen im wesentlichen aus den in einem vorgebbaren Zeitraum verbrauchten Kilowattstunden, gegebenenfalls aufgeschlüsselt nach verschiedenen Tarifen und Tarifzeiten und eventuell auch in der Angabe des Kosinus des Winkels zwischen Wirkleistung und Blindleistung, sofern das System Verbraucher enthält, die eine entsprechende Winkelverschiebung zwischen Wirkleistung und Blindleistung verursachen.

Der Integrationszeitraum beträgt vorzugsweise einen Monat und die jeweiligen Zeitfenster umfassen im allgemeinen einige Stunden, können jedoch in Einzelfällen auch kürzere Zeiträume umfassen, wenn zum Beispiel ein Energieversorgungsunternehmen zur Optimierung der Auslastung von Kraftwerken einen häufigeren Tarifwechsel im Verlaufe eines Tages vornimmt und Verbraucher entsprechend ein- und ausgeschaltet werden.

Dabei wird der Verbrauch in Zeitfenstern mit dem jeweils gleichen Tarif zweckmäßigerweise zusammengefaßt und die Aufschlüsselung erfolgt nur nach Zeiten mit unterschiedlichen Tarifen. Das entsprechende erste Modell kann relativ grob sein und teilt zum Beispiel das elektrische Energieverbrauchersystem in verschiedene Verbrauchergruppen ein, wie zum Beispiel die Verbraucher für Licht, Lüftung und sonstiges. Letzteres wären zum Beispiel in einem Bürohaus oder Verwaltungsgebäude Computer, elektrische Schreibmaschinen, Kaffeemaschinen, etc.. Auf der Basis von Erfahrungswerten für vergleichbare Systeme gibt das Modell dann die typischen Verbrauchsanteil und Verbrauchszeiten für elektrische Energie der einzelnen Verbrauchergruppen wieder. Beispielsweise kann ein typischer Tagesablauf modelliert werden, der zum Beispiel eine ständig vorhandene Grundlast umfaßt, weiterhin zu Beginn der Arbeitszeit einen relativ hohen Verbrauch an Energie für elektrisches Licht wiedergibt, der im Tagesverlauf abnimmt, während andere Energieverbraucher, wie zum Beispiel PC's, während der gesamten Arbeitszeit eingeschaltet bleiben und wieder andere Verbraucher, wie zum Beispiel Kaffeemaschinen, typischerweise während bestimmter Zeiträume am Vormittag und nach einer Mittagspause kleine Verbrauchsspitzen verursachen.

Derartige "Modelltage" sind selbstverständlich im Sommer und im Winter bzw. in den Übergangszeiten unterschiedlich, wobei sie jedoch während eines gegebenen Integrationszeitraumes von zum Beispiel einem Monat vorzugsweise unverändert bleiben. Außerdem sollen diese Modelltage nur den durchschnittlichen Energieverbrauch während eines Integrationszeitraumes wiedergeben, so daß also Energieverbrauchsschwankungen aufgrund von kurzfristigen Wetteränderungen weitgehend herausgemittelt werden. Einzelne Verbrauchergruppen bleiben darüberhinaus weitgehend unbeeinflußt von Witterungseinflüssen, wie zum Beispiel die bereits erwähnten PC's, elektrische Schreibmaschinen und Kaffeemaschinen.

Das Modell berücksichtigt dementsprechend zu einem gegebenen Zeitpunkt eines Modelltages nur einen bestimmten Prozentsatz der insgesamt für eine Verbrauchergruppe installierten maximalen Leistungsaufnahme, wobei dieser Prozentsatz der maximalen Leistungsaufnahme im Tagesverlauf entsprechend den Gewohnheiten der dort wohnenden oder tätigen Personen variiert.

Daraus ergibt sich insbesondere auch der Verbrauchsanteil während der vorgegebenen Zeitfenster mit jeweils unterschiedlichen Stromtarifen. Auf dieser Grundlage kann der hypothetische Stromverbrauch des Modells in gleicher Weise über einen vorgebbaren Zeitraum, zum Beispiel einen Monat, integriert werden. Dieser integrierte Energieverbrauch kann dann mit dem tatsächlichen Energieverbrauch des Systems in demselben Zeitraum verglichen werden. Wie bereits erwähnt, sollte der Integrationszeitraum aus praktischen Gründen vorzugsweise einen Monat betragen und das Modell sollte dann während eines solchen Monats als konstant angenommen werden, kann jedoch von Monat zu Monat variieren. Die variierenden Parameter des Modells sind im wesentlichen der prozentuale Nutzungsgrad der installierten Leistung einer Verbrauchergruppe, die Nutzungszeit und die Nutzungsdauer.

Anschließend erfolgt für einen gegebenen Integrationszeitraum der Vergleich des Energieverbrauchs des realen Systems mit dem hypothetischen Energieverbrauch des Modells. Unter Ausnutzung der von Energieversorgungsunternehmen zur Verfügung gestellten Daten kann dies in kürzester Zeit monatsweise für ein gesamtes Jahr oder auch für mehrere Jahre durchgeführt werden. Durch den Vergleich zwischen Modellverbrauch und realem Verbrauch erkennt man sehr schnell, in welchen Monaten typischerweise der reale Verbrauch über dem auf der Basis des Modells erwarteten Verbrauch liegt, woraus sich relativ einfach ergibt, welche Parameter des Modells gegebenenfalls zu verändern sind, um den Energieverbrauch des Modells dem realen Energieverbrauch anzupassen. Die, gegebenenfalls iterativ zu wiederholende, Anpassung der Parameter liefert schließlich ein zweites Modell, welches innerhalb vorgegebener Toleranzen dem tatsächlichen Energieverbrauch entspricht. Die Parameter des zweiten Modells liefern wiederum den Hinweis auf die Verbrauchergruppen, welche im Vergleich zum ersten Modell einen höheren Energieverbrauch haben. Dies kann gegebenenfalls noch durch Nachmessen, d.h. durch die gezielte Messung des Energieverbrauchs einer bestimmten Energieverbrauchergruppe, zum Beispiel für Licht oder Lüftung, verifiziert werden. Es hat sich jedoch herausgestellt, daß allein die Parameteranpassung, die zu dem zweiten Modell führt, sehr häufig genau in der Weise und für genau diejenigen Verbrauchergruppen erfolgen muß, die sich auch beim konkreten Nachmessen als die gegenüber dem ersten Modell überraschend großen Energieverbraucher herausstellen. Eine entsprechende Anpassung und Steuerung genau dieser Verbrauchergruppe derart, daß die Parameter in Richtung des ersten Modells verändert werden, führt dann zu einer erwünschten Energieeinsparung.

Sämtliche Verfahrensschritte des erfindungsgemäßen Verfahrens können automatisiert bzw. programmgesteuert ablaufen, wobei das erste Modell auch als Eingabegröße durch den Anwender ausgewählt werden kann. Hierzu können verschiedene Modelle in einem entsprechenden Speicher abgelegt sein.

Das erfindungsgemäße Verfahren hat den Vorteil, daß es in sehr einfacher Weise, schnell und kostengünstig durchgeführt werden und daß keine aufwendigen und sich über einen langen Zeitraum erstreckenden Einzelmessungen erforderlich sind, sondern das Einsparpotential schon allein anhand der Kenndaten des Energieverbrauchs, wie sie von Energieversorgungsunternehmen zumindest für größere Verbraucher im allgemeinen bereitgestellt werden, sofort abgeschätzt werden kann. Auch die konkreten Maßnahmen zur Energieeinsparung können dementsprechend schnell vorgenommen werden. Die Hemmschwelle, das Energieeinsparpotential überhaupt erfassen zu lassen, wird wegen der Einfachheit des Verfahrens wesentlich herabgesetzt, so daß ein solches Verfahren eine deutlich größere Akzeptanz hat als die herkömmlichen, aufwendigeren Verfahren, die für eine genügend genaue Aussage über das Energieeinsparpotential und die Verursacher eines übermäßigen Energieverbrauchs oftmals die Durchführung von Meßserien verlangen, die sich insgesamt über ein ganzes Jahr erstrecken, um alle jahreszeitlichen und witterungsbedingten Schwankungen zu erfassen.

Darüberhinaus sieht die vorliegende Erfindung auch vor, daß eine Grobeinschätzung des Energieeinsparpotentials durch Vergleich des Energieverbrauchs in verschiedenen Jahren, zum Beispiel über einen Zeitraum von fünf Jahren, vorgenommen wird. Der Unterschied zwischen dem maximalen und dem minimalen Energieverbrauch in einem gegebenen Monat in verschiedenen Jahren liefert oft schon einen groben Abschätzungswert für das Energieeinsparpotential.

Weitere Vorteile, Merkmale und Anwendungsmöglichkeiten der vorliegenden Erfindung werden deutlich anhand der folgenden Beschreibung eines konkreten Beispiels anhand von Tabellen und Figuren. Es zeigen:
- Tabelle 1: eine Zusammenstellung von Parametern eines gemäß der vorliegenden Erfindung zu analysierenden Objektes,
- Tabelle 2: gemäß einer Modellannahme die Auslastung der einzelnen elektrischen Verbraucher im Tagesverlauf während eines Sommertages und eines Wintertages, jeweils in 2 Stunden-Abständen,
- Tabelle 3: entsprechende Werte wie in Tabelle 2, jedoch für einen Wochenend- oder Feiertag,
- Tabelle 4: die angenommene Verteilung von Sommertagen, Wintertagen und Wochenend- bzw. Feiertagen in einem Jahr,
- Tabelle 5: entsprechend Tabelle 2 die Auslastung der elektrischen Verbraucher an einem Sommertag und einem Wintertag in einem Minimalmodell,
- Tabelle 6: analog zu Tabelle 3 die Auslastung gemäß Minimalmodell an einem Wochenend- oder Feiertag,
- Tabelle 7: die sich aus den Tabellen 5 und 6 ergebende Simulation des Energieverbrauches im Jahresverlauf,
- Figur 1: eine Messung des Energieverbrauchs im Tagesverlauf an einem Wintertag,

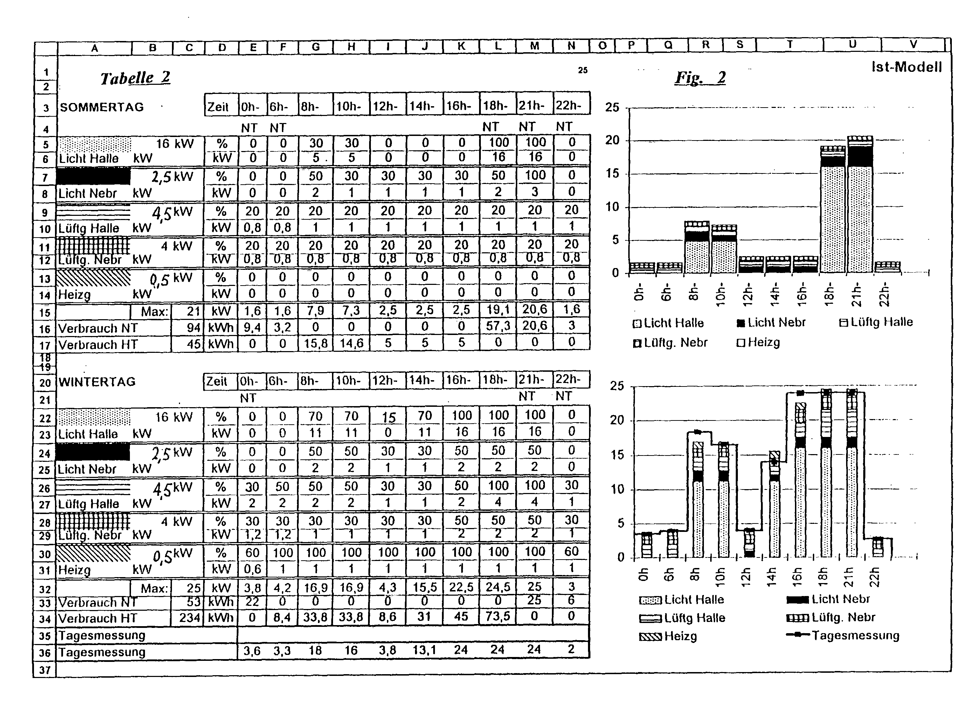

- Figur 2: eine grafische Darstellung der Werte aus Tabelle 2, wobei für den so modulierten Wintertag zusätzlich der gemessene Verlauf gemäß Figur 1 eingezeichnet ist,

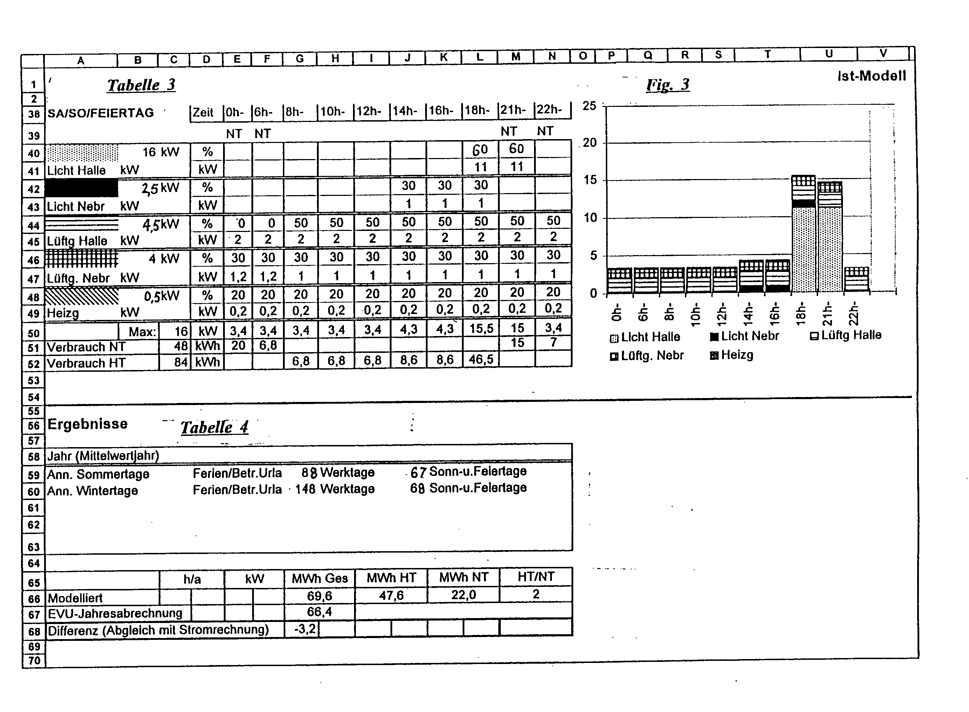

- Figur 3: die grafische Darstellung für einen Wochenend/Feiertag im Ist-Modell,
- Figur 4: Diagramme, die sich aus dem Tagesverlauf gemäß Tabelle 5 ergeben,
- Figur 5: ein Diagramm, welches dem Tagesverlauf gemäß Tabelle 6 entspricht,
- Figur 6: die Simulation des Jahresverlaufs, aufgeschlüsselt nach Hochtarif und Niedertarif,
- Figur 7: in einem Balkendiagramm die kumulierten Werte gemäß Tabelle 7 und
- Figur 8: in einem Tortendiagramm die anschauliche Darstellung des Minimalverbrauchs und der Einsparpotentiale.

Der erste Schritt bei der Durchführung des erfindungsgemäßen Verfahrens besteht in der Erfassung der konkret nachprüfbaren Parameter des Objektes. Im vorliegenden Fall ist das Objekt eine Sporthalle, deren Nutzungszeiten zwischen morgens 08.00 Uhr bis abends 24.00 Uhr liegen. Die Hallenfläche beträgt ca. 1.300 m², und die Nebenräume und Flure umfassen eine Fläche von ca. 1.200 m². Die Halle wird vormittags teilweise für den Schulsport genutzt, abends von Sportvereinen und am Wochenende auch für Wettkämpfe in einer Tischtennisliga.

Aus diesen Daten und aus einschlägigen Normen und Bestimmungen für Beleuchtung, Lüftung und Heizung läßt sich ein Minimalmodell erstellen, aus welchem sich der minimale Energiebedarf bei den verschiedenen Nutzungsarten und die sich dementsprechend nach der deutschen Industrienorm 5035 zu installierende elektrische Leistungskapazität ergibt.

Dem gegenübergestellt ist die tatsächlich installierte Leistungskapazität für das Ist-Modell im unteren Teil der Tabelle 1 (Spalte "Besichtigung"). Wie man anhand eines Vergleichs zwischen Minimalmodell und Ist-Modell erkennen kann, unterscheiden sich die gemäß diesen beiden Modellen installierten bzw. zu installierenden Leistungskapazitäten nicht nennenswert voneinander.

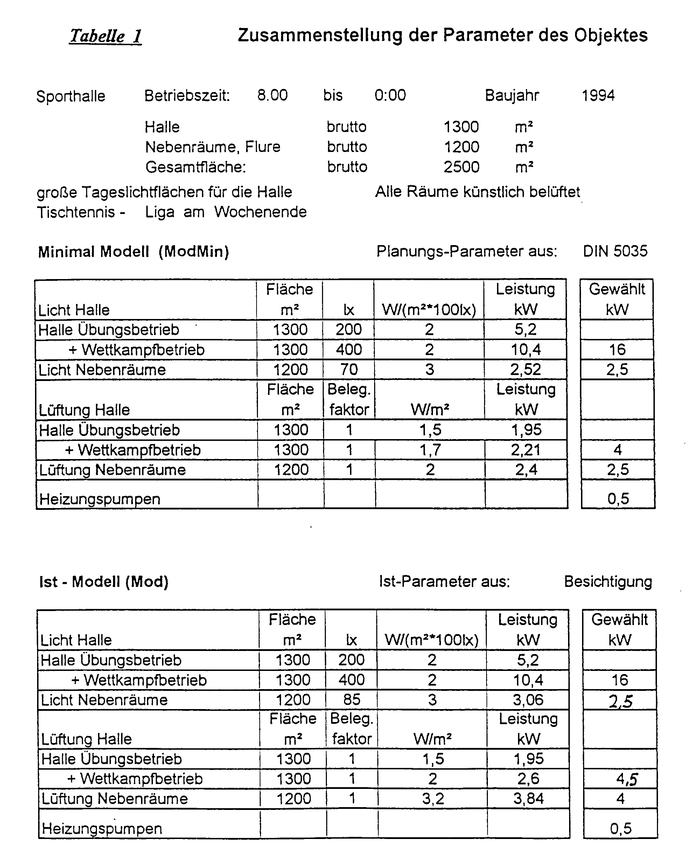

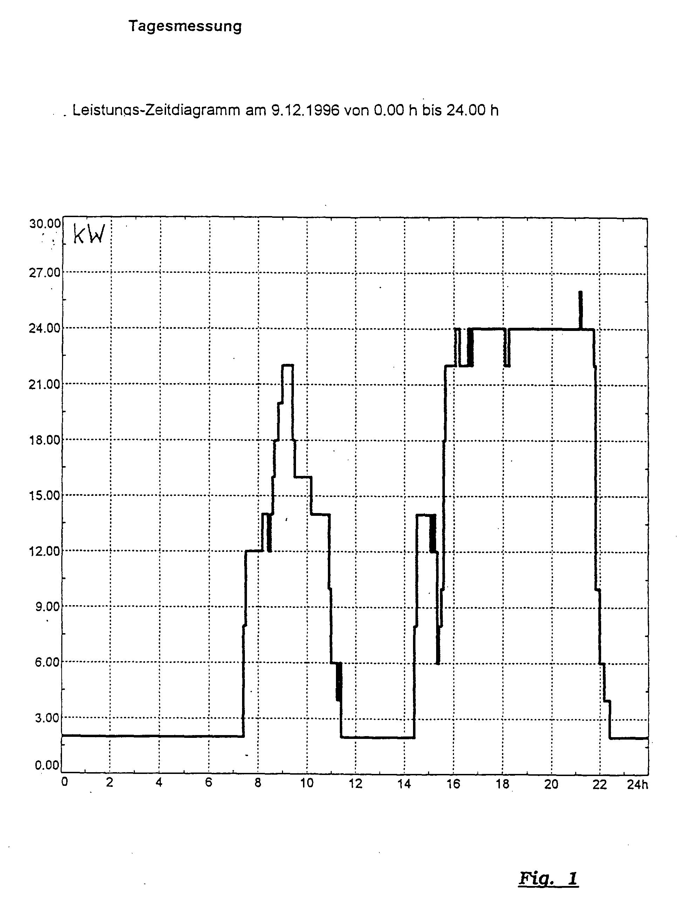

Voraussetzung für die Erstellung des Ist-Modells ist darüber hinaus das Ergebniss einer Tagesmessung, d. h. der elektrische Energieverbrauch aufgeschlüsselt nach Zeitfenstern und intergriert, wie er in Figur 1 wiedergegeben ist. Wie man erkennt, gibt es ausgeprägte Verbrauchsspitzen im Zeitraum zwischen etwa 8.00 und 11.00 Uhr am Vormittag und von etwa 16.00 bis 22.00 Uhr am Abend. Die minimale Leistungsaufnahme liegt aber auch außerhalb der Nutzungszeiten bei ca. 2 kW.

Es erfolgt nun die Auswahl eines Ist-Modells aus einer Mehrzahl verschiedener Modelle, die vorzugsweise in einem Speicher abgelegt sind. Für die Auswahl des Modells ist vor allem die Art des Objektes, im vorliegenden Falle also eine Sporthalle, primär ausschlaggebend. Die Modellgruppe "Sporthalle" kann ihrerseits aus mehreren Modellen bestehen (z. B. unter Einbezug oder ohne Wochenendnutzung, mit oder ohne Nutzung durch eine Schule und mit oder ohne Abendnutzung), umfaßt aber auf jeden Fall mindestens ein Modell. Ein solches Modell beinhaltet eine gewisse Grundlast, die im Falle von Sporthallen notwendigerweise durch Verbraucher wie Heizungspumpen und Lüftungsanlagen veranlaßt sein muß, da alle anderen Verbrauchsarten wie Sporthallenlicht und Licht in den Nebenräumen außerhalb der Nutzungszeiten weitgehend auszuschließen sind, zumindest wenn das Objekt, wie bei Sporthallen üblich, von einem Hausmeister überwacht wird.

Zweckmäßigerweise gelangt man zu dem Ist-Modell am besten dadurch, daß man unter Berücksichtigung des vorstehend Gesagten zunächst ein Minimalmodell auswählt, dessen äußere, unabänderliche Parameter mit den unabänderlichen Parametern des Ist-Modelles übereinstimmen. Diese unabänderlichen Parameter sind vor allem die installierte elektrische Leistung, die Größe und Bauart des Objektes und die konkret bekannten Nutzungszeiten.

Die Nachbildung des Ist-Modells erfolgt dann durch Variationen der veränderbaren Parameter, konkret also des jeweiligen Ausmaßes der elektrischen Energienutzung während der Nutzungszeiten des Objektes.

Variationen sind z. B. möglich in dem Ausmaß der Inanspruchnahme der Lüftung und des Lichtes in der Sporthalle. Dementsprechend werden insbesondere diese beiden Parameter geändert, wobei die gesamte installierte Leistungskapazität für jede der Nutzungsarten einen oberen Grenzwert liefert, wobei die konkrete Nutzung zwischen 0 und 100% dieses Maximalwertes variieren kann. Dies sind die Parameter, die entsprechend dem ausgewählten Modell während eines simulierten Tagesablaufes variiert werden können. Diese Parametervariation erfolgt in der Weise, daß der so simulierte Verbrauch räherungsweise dem gemessenen Tagesverlauf entspricht.

Die so ermittelten Parameter liefern gleichzeitig auch ein Profil des Verbraucherverhaltens. Wenn z. B. die Tagesmessung ergibt, daß abends während des Übungsbetriebes praktisch die gesamte installierte Leistung in Anspruch genommen wird, so läßt sich daraus ableiten, daß Lüftung und Licht in der Halle im wesentlichen zu 100% beansprucht werden, insbesondere wenn diese Verbrauchergruppen nicht stufenlos, sondern nur in bestimmten Stufen einstellbar sind.

Im Rahmen des ersten Modells wird dieses Verbraucherverhalten dann auch auf andere Tage, insbesondere auch auf Wochenend- und Sommertage transferiert, woraus sich die in den Tabellen 2 und 3 im einzelnen angegebenen Nutzungsgrade für die einzelnen Verbrauchergruppen und Zeiten eines Sommertages, eines Wintertages und eines Wochenend/Feiertages ergeben. Das Wintertagsprofil wird dann durchgehend als für alle Wintertage gültig angenommen, ebenso auch das daraus abgeleitete Sommertagsprofil, was sich im wesentlichen von dem Wintertagsprofil nur dadurch unterscheidet, daß der Nutzungsgrad des Lichtes während der hellen Mittagsstunden von 12.00 bis 18.00 Uhr mit Null angenommen wird und im übrigen reduziert wird. Das Feiertagsprofil unterscheidet sich von dem gemessenen Wintertagsprofil vor allem durch eine zeitlich stärker eingeschränkte Nutzung.

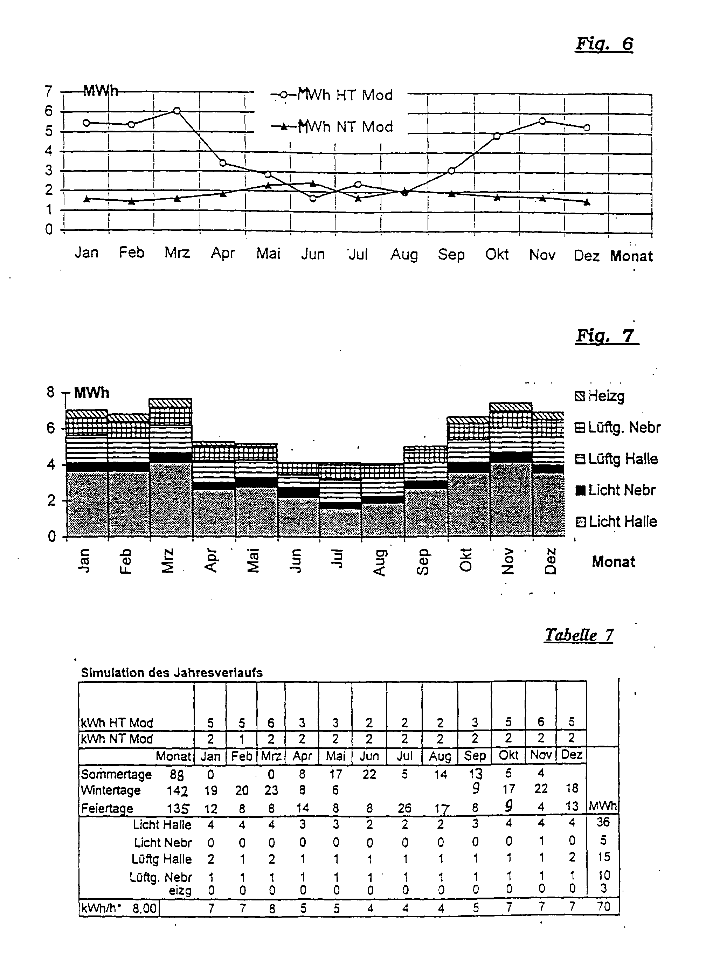

Tabelle 4 gibt im einzelnen an, wieviele Werktage und Sonn- und Feiertage im Sommer und wieviele Werktage und Sonn- und Feiertage im Winter zugrundegelegt werden. Mit den jeweiligen Tagesprofilen und der Anzahl der jeweiligen Tage läßt sich der gesamte Jahresverbrauch simulieren, wobei sich aus den speziellen Verbrauchszeiten im Tagesprofil auch noch die Verbrauchsanteile im Niedertarif und im Hochtarif ergeben. Diese Verbrauchskurven sind im Jahresverlauf in Figur 6 wiedergegeben. Figur 6 zeigt den kumulierten Verbrauch aus Niedertarif und Hochtarif, jedoch in diesem Fall aufgeschlüsselt nach Nutzungsarten.

In Zahlen ist der Jahresverlauf gemäß Figur 6 in Tabelle 7 wiedergegeben.

In völlig analoger Weise wird auch mit einem Minimalmodell verfahren. Das Minimalmodell, dessen Parameter in Tabelle 1 zusammengestellt sind, stimmt hinsichtlich dieser Parameter noch weitgehend mit dem Ist-Modell überein, was sich schon daraus zwangsweise ergibt, daß Parameter wie die Flächengrößen und die installierte Leistungskapazität durch das konkrete Objekt festgelegt sind. Geringfügige Unterschiede ergeben sich offenbar in der installierten Leistung des Lichtes für die Nebenräume und auch in der installierten Leistung für die Lüftung der Nebenräume. Hier sind im Minimalmodell geringere installierte Leistungskapazitäten angenommen als sie nach dem Ist-Modell tatsächlich vorhanden sind. Dies ist z.B. ein Hinweis darauf, daß bei dem konkreten Objekt geringfügig größere elektrische Leistungskapazitäten für die Lüftung der Nebenräume installiert sind, als dies anhand der konkreten Gegebenheiten tatsächlich notwendig gewesen wäre. Wie jedoch die spätere Auswertung noch zeigen wird, ist dies für das Einsparpotential von untergeordneter Bedeutung. Im übrigen ergeben sich Unterschiede zwischen dem Minimalmodell und dem Ist-Modell nur durch den konkreten Nutzungsgrad der einzelnen Verbraucher bei den verschiedenen Nutzungsarten und Tageszeiten, was mehr oder weniger schon daraus folgt, daß das Ist-Modell aus dem Minimalmodell im wesentlichen durch Variation der veränderbaren Parameter entstanden ist, nachdem das Minimalmodell zunächst auf der Basis der unabänderlichen Parameter des Objektes ausgewählt wurde.

Das Minimalmodell sieht z. B. vor, daß während eines Sommertages die Beleuchtung den im Durchschnitt tatsächlich herrschenden Lichtverhältnissen angepaßt wird, d.h. daß auch am frühen Morgen beim Schulbetrieb das Hallenlicht im Durchschnitt nur zu 25% genutzt wird und daß dieser Nutzungsgrad im Verlaufe des Vormittags entsprechend den sich ändernden Lichtverhältnissen schnell angepaßt wird. Es versteht sich, daß es sich dabei nur um durchschnittliche Nutzungsgrade handelt und daß z. B. an einem sehr hellen, sonnigen Sommertag das Licht auch morgens um 08.00 Uhr überhaupt nicht eingeschaltet zu werden braucht, während es an einem dunklen, verregneten Tag möglicherweise zu 50% der installierten Kapazität genutzt werden muß.

Grundsätzlich geht das Minimalmodell davon aus, daß die gleiche Hallennutzung wie im Falle des Ist-Modells stattfindet, daß jedoch die einzelnen Verbraucher nur in dem Umfang und in dem Ausnutzungsgrad eingeschaltet werden, der für die jeweilige Nutzung tatsächlich erforderlich ist.

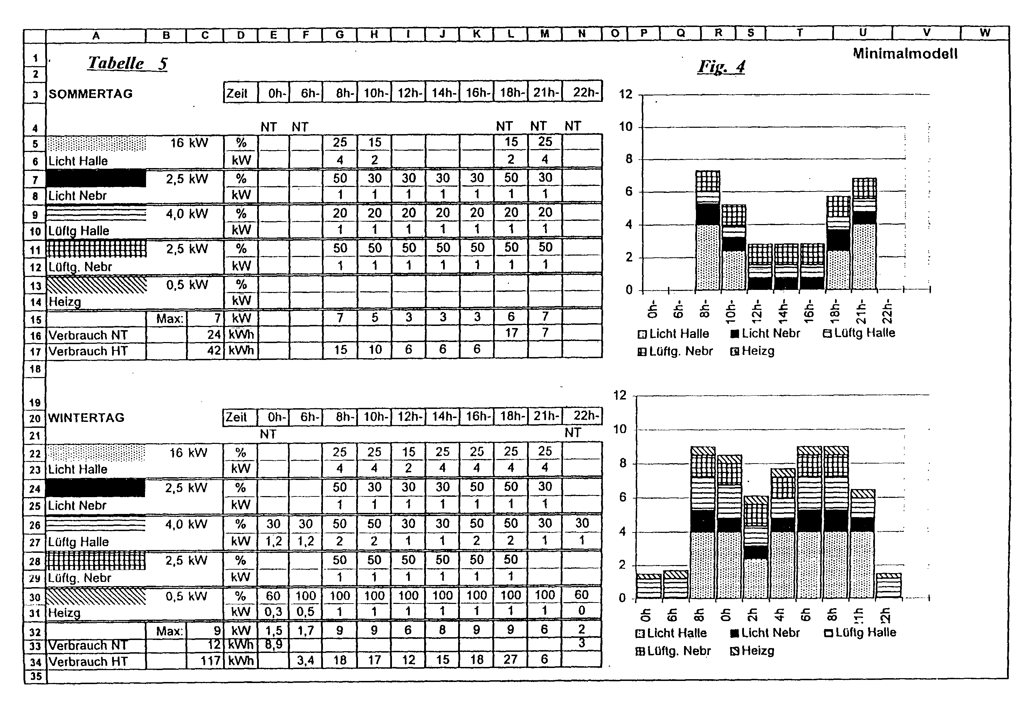

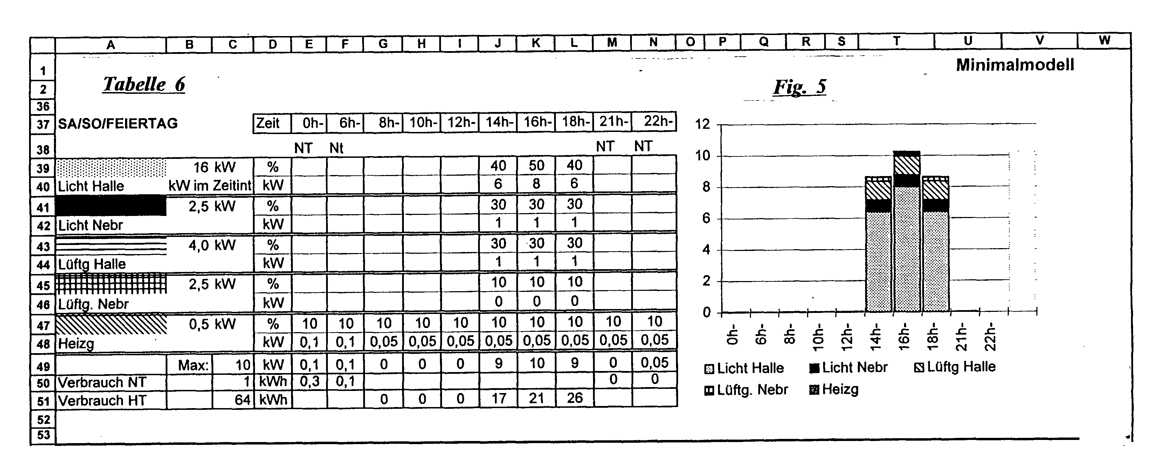

Grafisch sind die Verbrauchsdaten von Sommertag und Wintertag des Minimalmodells in Figur 4 wiedergegeben, während Figur 5 die entsprechende grafische Darstellung für einen Feiertag bzw. einen Wochenendtag zeigt.

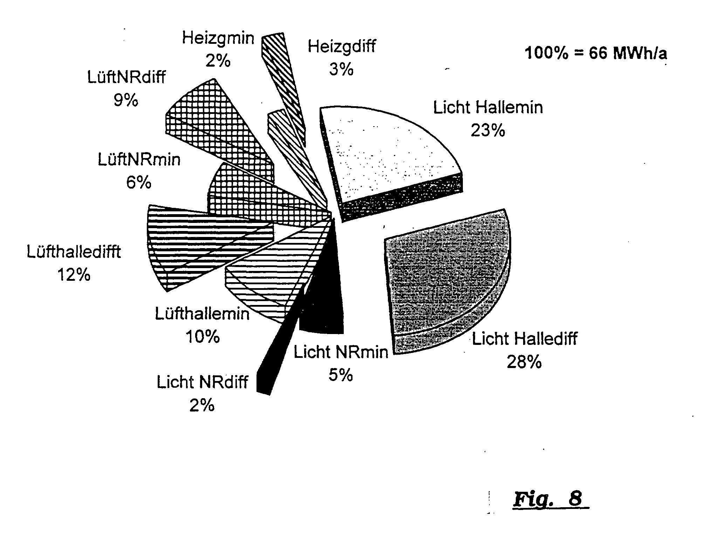

Der auf der Basis des Minimalmodells simulierte Jahresverbrauch ist nicht nochmals wiedergegeben, sondern ergibt sich nur noch aus dem Tortendiagramm gemäß Figur 8.

Zunächst ist festzuhalten, daß der in den Figuren 6 und 7 sowie in Tabelle 7 wiedergegebene, simulierte Jahresverlauf des Ist-Modells zu einem Gesamtverbrauch von ca. 70 MWh führt, was relativ gut mit dem tatsächlichen, gemessenen Verbrauch von 66,4 MWh übereinstimmt, so daß davon ausgegangen werden kann, daß auch die einzelnen, simulierten Verbrauchsarten der Realität relativ nahekommen.

Das Tortendiagramm ist auf den tatsächlichen Verbrauch von ca. 66 MWh pro Jahr zurückgerechnet worden. Dieser Wert entspricht der gesamten "Torte". Herausgeschnittene und aus dem Tortenkreis radial herausgezogene Stücke geben das Einsparpotential wieder, während die innen verbliebenen Tortenstücke den Verbrauch gemäß Minimalmodell repräsentieren.

Aus dieser Darstellung läßt sich ablesen, daß das mit Abstand größte Einsparpotential in der Beleuchtung der Halle liegt, wobei auch die Lüftung der Halle und der Nebenräume ebenfalls noch nennenswerte Einsparpotentiale bieten. Das Licht der Nebenräume würde dagegen bei optimierter Nutzung nur ein Einsparpotential von 2% des Gesamtenergieverbrauches ausmachen, und auch der optimierte Betrieb für die Umwälzpumpen der Heizung könnte maximal einen Beitrag von 3% zur Energieersparnis liefern. Wenn also z. B. die Differenzen im Energieverbrauch von Heizung und Licht der Nebenräume durch eine möglicherweise zu große installierte Leistung bedingt sind, so würde sich bei dem geringen Einsparpotential eine Neuinvestition zur Verringerung dieser installierten Leistungskapazitäten bei weitem nicht so schnell bezahlt machen wie andere Investitionen oder Maßnahmen, welche z. B. das Hallenlicht und die Hallenlüftung auf das jeweils erforderliche Maß reduzieren. Das erfindungsgemäße Verfahren liefert demnach ohne eine detaillierte Langzeitmessung der einzelnen Verbraucher bereits aufgrund relativ schnell und leicht verfügbarer Daten eine fundierte Aussage über das Einsparpotential und insbesondere über die konkreten elektrischen Verbraucher, die das größte Einsparpotential bieten. Dies ermöglicht gezielte und wirksame Maßnahmen zur Energieeinsparung, während überflüssige und im Ergebnis nicht wirksame Maßnahmen von vornherein vermieden werden.

## Patentansprüche

1. Verfahren zum Erfassen des Energieeinsparpotentials eines elektrischen Energieverbrauchersystems, gekennzeichnet durch die folgenden Schritte:
a) Messen der Kenndaten des elektrischen Energieverbrauchs, vorzugsweise aufgeschlüsselt nach Zeitfenstern und Integration dieser Kenndaten über einen vorgebbaren Zeitraum,
b) Auswählen eines ersten Modells für das elektrische Energieverbrauchersystem auf der Basis von Erfahrungswerten für vergleichbare Energieverbrauchersysteme, wobei das erste Modell veränderbare Parameter hat, und Integration der Kenndaten des elektrischen Energieverbrauchs des ersten Modells, gegebenenfalls in entsprechenden Zeitfenstern wie bei dem realen System, und Integration über denselben vorgebbaren Zeitraum wie bei dem realen System,
c) Vergleich der gemessenen integrierten Kenndaten mit den auf der Grundlage des ersten Modells berechneten integrierten Kenndaten des elektrischen Energieverbrauchs und Bestimmen der Differenz der Kenndaten des Modells und des realen Systems,
d) Anpassen der Parameter des ersten Modells zur Erstellung eines zweiten Modells des elektrischen Energieverbrauchersystems, derart, daß die integrierten Kenndaten des zweiten Modells mit den entsprechenden integrierten gemessenen Kenndaten des realen Energieverbrauchersystems innerhalb vorgebbarer Toleranzen übereinstimmen und
e) Vergleichen der Parameter der ersten und zweiten Modelle zur Identifikation derjenigen Verbraucher des elektrischen Energieverbrauchersystems, welche den gegenüber dem ersten Modell abweichenden Verbrauch bewirken.

2. Verfahren nach Anspruch 1, **dadurch gekennzeichnet**, daß die Zeitfenster den jeweiligen Tageszeiten bzw. Zeitfenstern für unterschiedliche Stromtarife entsprechen.

3. Verfahren nach Anspruch 1 oder 2, dadurch gekennzeichnet, daß der Integrationszeitraum mindestens eine Woche, vorzugsweise einen Monat umfaßt.

4. Verfahren nach einem der Ansprüche 1 bis 3, dadurch gekennzeichnet, daß die Modellparameter die Einschaltdauer sowie den prozentualen Anteil des maximalen Energieverbrauchs jeweils einer Verbrauchergruppe umfassen.

5. Verfahren nach einem der Ansprüche 1 bis 4, dadurch gekennzeichnet, daß zwecks Vergleich mit dem zweiten Modell eine Messung der Kenndaten des elektrischen Energieverbrauchs einzelner Verbraucher oder Verbrauchergruppen erfolgt.

6. Verfahren nach einem der Ansprüche 1 bis 5, dadurch gekennzeichnet, daß als erstes Modell ein in seinem äußeren, unabänderlichen Parametern mit den gegebenen unabänderlichen Parametern des konkreten, zu untersuchenden elektrischen Verbrauchersystems übereinstimmt, woraufhin eine Variation der variablen Parameter des elektrischen Energieverbrauchs bis zur wesentlichen Übereinstimmung des Gesamtenergieverbrauchs über einen größeren, vorgegebenen Zeitraum zwischen dem variierten Minimalmodell und dem konkreten Objekt erfolgt.

7. Verfahren zum Steuern des Energieverbrauchs eines elektrischen Energieverbrauchersystems, dadurch gekennzeichnet, daß das Energieeinsparpotential nach einem der Ansprüche 1 bis 5 erfaßt wird und daß die Parameter des realen Energieverbrauchersystems denen des ersten Modells angenähert werden.

## Claims

1. A method of detecting the energy-saving potential of an electrical energy consumer system, characterised by the following steps:
a) measurement of the characteristic data of electrical energy consumption, preferably classified in accordance with time windows, and integration of said characteristic data over a predeterminable period of time,
b) selection of a first model for the electrical energy consumer system on the basis of empirical values for comparable energy consumer systems, wherein the first model has variable parameters, and integration of the characteristic data of the electrical energy consumption of the first model, possibly in corresponding time windows as in the real system, and integration over the same predeterminable period of time as in the real system,
c) comparison of the measured integrated characteristic data with the integrated characteristic data of electrical energy consumption, calculated on the basis of the first model, and determination of the difference of the characteristic data of the model and the real system,
d) adaptation of the parameters of the first model to produce a second model of the electrical energy consumer system, in such a way that the integrated characteristic data of the second model coincide with the corresponding integrated measured characteristic data of the real energy consumer system within predeterminable tolerances, and
e) comparison of the parameters of the first and second models for identification of those consumers of the electrical consumer system, which involve the consumption that differs in relation to the first model.

2. A method according to claim 1 characterised in that the time windows correspond to the respective times of day or time windows for different power tariffs.

3. A method according to claim 1 or claim 2 characterised in that the integration period includes at least a week and preferably a month.

4. A method according to one of claims 1 to 3 characterised in that the model parameters include the switch-on duration and the percentage proportion of the maximum energy consumption of a respective consumer group.

5. A method according to one of claims 1 to 4 characterised in that for the purposes of comparison with the second model measurement of the characteristic data of the electrical energy consumption of individual consumers or consumer groups is implemented.

6. A method according to one of claims 1 to 5 characterised in that as the first model one coincides in its external invariable parameters with the given invariable parameters of the specific electrical consumer system to be investigated, whereupon a variation in the variable parameters of electrical energy consumption is effected until there is substantial identity of the total energy consumption over a greater predetermined period of time between the varied minimal model and the specific object.

7. A method of controlling the energy consumption of an electrical energy consumer system characterised in that the energy-saving potential is detected according to one of claims 1 to 5 and that the parameters of the real energy consumer system are approximated to those of the first model.

## Revendications

1. Procédé pour détecter le potentiel d'économie d'énergie d'un réseau consommateur d'énergie électrique, caractérisé par les étapes suivantes :
a) mesure des caractéristiques de la consommation d'énergie électrique, de préférence ventilée selon les fenêtres de temps, et intégration de ces caractéristiques sur une période pouvant être prédéfinie,
b) sélection d'un premier modèle pour le réseau consommateur d'énergie électrique, sur la base de valeurs acquises par l'expérience pour des réseaux comparables consommateurs d'énergie, le premier modèle ayant des paramètres variables, et intégration des caractéristiques de la consommation d'énergie électrique du premier modèle, éventuellement dans des fenêtres de temps correspondant à celles du réseau réel, et intégration sur la même période pouvant être prédéfinie que dans le cas du réseau réel,
c) comparaison des caractéristiques intégrées mesurées et des caractéristiques intégrées, calculées sur la base du premier modèle, de la consommation d'énergie électrique, et détermination de la différence entre les caractéristiques du modèle et celles du système réel,
d) ajustement des paramètres du premier modèle pour établir un deuxième modèle du système consommateur d'énergie électrique, de telle sorte que les caractéristiques intégrées du deuxième modèle coïncident avec les caractéristiques mesurées intégrées correspondantes du réseau réel consommateur d'énergie, dans les limites de tolérances pouvant être prédéfinies, et
e) comparaison des paramètres du premier et du deuxième modèles pour identifier les consommateurs du réseau consommateur d'énergie électrique qui ont une consommation s'écartant de celle du premier modèle.

2. Procédé selon la revendication 1, caractérisé en ce que les fenêtres de temps correspondent aux différentes périodes ou fenêtres de temps journalières pour les différents tarifs de courant.

3. Procédé selon la revendication 1 ou 2, caractérisé en ce que la durée d'intégration est d'au moins une semaine et de préférence d'un mois.

4. Procédé selon l'une des revendications 1 à 3, caractérisé en ce que les paramètres du modèle englobent la durée de fonctionnement, ainsi que la proportion en pourcentage de la consommation maximale d'énergie d'un groupe de consommateurs donné.

5. Procédé selon l'une des revendications 1 à 4, caractérisé en ce que, à des fins de comparaison avec le deuxième modèle, on procède à une mesure des caractéristiques de la consommation d'énergie électrique de consommateurs ou de groupes de consommateurs individuels.

6. Procédé selon l'une des revendications 1 à 5, caractérisé en ce qu'on utilise en tant que premier modèle un modèle dont les paramètres extérieurs non variables du réseau consommateur d'énergie électrique à étudier coïncident avec les paramètres non-variables prédéfinies de ce réseau, ce après quoi on procède à une variation des paramètres variables de la consommation d'énergie électrique jusqu'à arriver pour ainsi dire à une coïncidence de la consommation globale d'énergie sur une période plus longue et prédéfinie, entre le modèle minimal que l'on a fait varier et le système concret.

7. Procédé pour piloter la consommation d'énergie d'un système consommateur d'énergie électrique, caractérisé en ce que le potentiel d'économie d'énergie est déterminé selon l'une des revendications 1 à 5, et que l'on donne aux paramètres du système réel consommateur d'énergie des valeurs proches de celles du premier modèle.
